# EUROPEAN PATENT APPLICATION

(11) **EP 1 976 366 A1**
(43) Date of publication of application: **01.10.2008**
(21) Application number: 07105355.7
(22) Date of filing: 30.03.2007
(51) Int. Cl.: H05K 13/04

(54) **Device and apparatus at a component mounting machine**

(71) Applicant: Mydata Automation AB, 168 66 Bromma (SE)
(72) Inventor: Dahlberg, Martin, SE-438 34, LANDVETTER (SE)
(74) Representative: Skagersten, Thomas

(57) **Abstract**

A component receiving device, and a component feeding apparatus including such a component receiving device and a connected tube, for use at a component mounting machine. The component receiving device is arranged for consecutively receiving a plurality of components from a connected component tube provided with a plurality of consecutively stored components and having a tube ridge at the bottom of the tube for supporting the components. The tube ridge has a saddle-like cross-section with an upper component-supporting surface and with an opposite lower tube ridge surface facing a downwardly open space therebelow. The device comprises positioning means for co-operation with the lower tube ridge surface for positioning a connected tube in a predetermined, operational position relative to the component receiving device.

## Description

### Technical field

The present invention relates to a component receiving device, and a component feeding apparatus including such a component receiving device and a connected tube, for use at a component mounting machine.

### Technical Background

One type of component mounting machines uses components such as conventional integrated circuits consecutively stored in elongate plastic tubes. Typically, the tubes have a bottom part with a ridge, hereafter called a tube ridge, along the length for supporting the components consecutively stored inside the tube. Many tube ridges have a saddle-like cross-section, with an upper component-supporting surface and an opposite lower tube ridge surface facing a downwardly open space therebelow. Accordingly, the tube ridge supports the consecutively stored components, protecting the fragile legs of the component, i.e. the component and its legs are elevated from the tube bottom floor. Due to different shapes and sizes of the components, the tube ridge and the cross-section of the tube varies, i.e. the size and cross-section of the tube depends on the type of stored component. In addition, another parameter affecting the tube shape and dimensions is the manufacturer of the tube, since the tubes are not standardized. Accordingly, there exist numerous tube variants.

The tubes are loaded in a vibrating tube magazine having a component receiving device for each tube, such as for example VMF30 manufactured by MYDATA automation AB. Each component receiving device has a device ridge corresponding to said tube ridge for supporting a received component. The components within the tubes are moved forward into the component receiving device by vibrating the magazine longitudinally thereof. Each tube has been mounted in the magazine in such a way that a forward end thereof abuts against a stop at the respective component receiving device while resting on a tube bottom supporting surface in the magazine. Besides providing a stop for the forward tube end, the component receiving device also serves in providing a component receiving space with a well-defined component picking position. The forward end of a mounted or connected tube faces the component receiving space such that consecutively stored components from the tube may enter the space and thereby the picking position. A picking head picks the component at the well-defined picking position of the component receiving space and transfers the component to the site where it is mounted. Thus, the position of the component receiving device determines the picking position for the components in the tube.

A component receiving device can be arranged to be connected to different type of tubes, i.e. the magazine is provided with a construction for stopping and connecting, within reasonable limits, a tube end with a cross-section of varying size and shape. Each tube will be positioned relative to the component receiving device for obtaining a smooth and secure passage of components from the tube to the component receiving device. The tube is then in an operational position relative to the component receiving device, enabling consecutively stored components to leave the tube and enter the component receiving space. For a smooth passage, the tube end should be positioned relative to the component receiving space of the component receiving device such that a component leaving the end opening of the tube travels downwards and safely enters the component receiving space.

Usually when a component is properly located in the component receiving space, this first component acts as a stopper for a following component from the tube. This following component in line can only enter the component receiving space when the first component has been picked up. Sometimes, because of various tube cross-sections, different component sizes or the combination thereof, a following component can climb on top of the first component, thereby causing problems.

### Summary of the invention

An object of the invention is to provide a novel solution for providing and controlling a vibratory component feeding in a component mounting machine. This and other objects are achieved by providing a component receiving device, a component feeding apparatus and a use of a combination of a component receiving device and a component tube having the features defined in the appended independent claims. Example embodiments are defined in the dependent claims.

According to a first aspect of the invention, there is provided a component receiving device for consecutively receiving a plurality of components from a connected component tube arranged for containing a plurality of consecutively stored components and having a tube ridge at the bottom of the tube for supporting the plurality of components, the tube ridge having a saddle-like cross-section with an upper component-supporting surface and with an opposite lower tube ridge surface facing a downwardly open space therebelow, said component receiving device comprising positioning means for co-operation with a said lower tube ridge surface for positioning a connected tube in a predetermined, operational position relative to the component receiving device.

According to a second aspect of the invention, there is provided a component feeding apparatus, comprising a component tube, arranged for containing a plurality of consecutively stored components and having a tube ridge at the bottom of the tube for supporting the plurality of components, said tube ridge having a saddle-like cross-section with an upper component-supporting tube ridge surface and an opposite lower tube ridge surface, facing a downwardly open space therebelow, and a component receiving device connected to said tube for consecutively receiving components from said tube into a component receiving space having a device ridge for supporting a received component, the component receiving device comprising positioning means for co-operation with said tube for positioning the tube in a predetermined, operational position relative to the component receiving device, wherein said positioning means comprise means extending into said downwardly open space of said tube and being in co-operation with said lower tube ridge surface such that the tube ridge and the device ridge have a pre-determined height position relative to each other.

According to a third aspect of the invention, there is provided in a combination of a component tube, arranged for containing a plurality of consecutively stored components and having a bottom tube ridge for supporting the plurality of components, the tube ridge having a saddle-like cross-section with an upper component-supporting surface and an opposite lower tube ridge surface facing a downwardly open space therebelow, and a component receiving device, arranged for connection with said tube to consecutively receive components from said tube and comprising means for co-operation with said tube for positioning said tube in a predetermined operational position relative to said component receiving device when said tube is connected to said component receiving device, use of said lower surface of said tube ridge for positioning the tube in said predetermined, operational position relative to the component receiving device.

Thus the invention is based on the insight of providing and using positioning means of a component receiving device for co-operation with a said lower tube ridge surface of a connected component tube, for positioning the component tube relative the component receiving device. The use of such positioning means makes it easy to obtain connection between the tube and the component receiving device and possible to control a component feeding movement from a component tube into a component receiving device in an advantageously accurate and reliable manner.

As will be understood, positioning a component tube end relative to a component receiving device by means of a said lower tube ridge surface of the tube, will bring the component supporting ridge of the tube in a very well-defined position relative a component supporting ridge of said device, irrespectively of the height of the "legs" of the saddle-like cross-section of the tube ridge and the material thickness of the tube bottom floor. Contrary thereto, positioning according to prior art, only levels the lower base surface of the tube with the lower base surface of the receiving device.

Consequently, a component receiving device according to the invention which co-operates with a said lower tube ridge surface by means of said positioning means can be connected to a number of component tubes having a variety of dimensions and cross-sections while still securing a well-defined mutual positioning between the tube ridge and the receiving device ridge. Also, the connection between a component tube end and a component receiving device according to the invention will be facilitated, as will be discussed in more detail later on.

According to an example embodiment, the positioning means of the component receiving device, in the following also referred to as a positioner, for co-operation with a said lower surface of a tube ridge includes a protrusion. Preferably, the protrusion has the shape of a tongue, in other words a protruding tongue, suitably with a top or upper contacting tongue surface, in the following referred to as a top contact surface, for said co-operation with the tube ridge lower surface. In use, a tube can be advanced towards the positioner, whereby the positioner is introduced into the open space under the ridge of the tube. More exactly, the positioner engages at least with the lower tube ridge surface of the advancing tube, providing the desired operational positioning of the tube.

According to another example embodiment, said top contact surface on the positioner of the component receiving device includes a positioning surface or positioning surface portion preferably at a base end of said protrusion of the positioner for positioning an advanced or forward tube end. The protrusion of the positioner is thereby entirely introduced into the open space under said ridge of the tube. Consequently, a forward end of a connected tube is in a desired operational position.

In another example embodiment, said top contact surface an in particular said positioning surface on the positioner of the component receiving device include a flat surface giving good contact with said lower surface of a tube ridge, since this lower surface mostly is a generally flat surface. However, as will be understood, the contact surface need not be extensive as long as a desired height positioning effect is obtained. Thus, in one extreme, the contact surface between the positioner and the tube ridge lower surface could be more or less a line surface, giving a well-defined height positioning effect that can be supplemented by a lateral positioning effect obtained in a suitable way, as will be discussed later on.

In a further example embodiment, said positioning surface of the top contact surface is a laterally extending surface giving a good contact in the lateral direction with said lower surface of the tube ridge. Thus, the positioner and the lower tube ridge surface is here engaging and co-operating with each other along a laterally extending contact surface, in the following referred to as a lateral contact surface, giving a well-defined height positioning effect while also preventing the connected tube from wobbling or being in an unsteady state. As will be understood, said lateral contact surface may be a line surface portion.

Moreover, as will be understood the lateral width of said top contact surface should be lesser than that of said lower tube ridge surface such that the lower tube ridge surface of a forward tube end can be contacted. However, an adapted lateral width of said top contact surface to the width of the lower tube ridge surface can laterally guide an advancing tube.
This is to ensure a good contact between said top contact surface and said lower tube ridge surface.

Furthermore, according to another example embodiment said top contact surface on the positioner of the component receiving device has an inclination or sloping surface, descending along the protruding direction of the protruding tongue. An inclined top contact surface ensures a correct contact between said positioning surface and said lower tube ridge surface when a connected forward tube end portion will or should have an inclination relative a supporting surface, which commonly supports both the tube and the component receiving device. Such an inclination of the forward tube end can arise when a tube is connected to a positioner. For example, when the tube with a forward contacting end, is advanced along said supporting surface and is connected to the positioner of the component receiving device, the lower tube ridge surface of the forward contacting end first contacts a front portion of the sloping top contact surface of the positioner. Secondly, when the tube is further advanced the forward end is forced upwards along the sloping top contact surface, thereby elevating the forward contacting end of the tube relative the rest of the tube. This can give the tube end portion an upward inclination.

As will be understood the degree of inclination of the inclined top contact surface of the receiving device suitably is higher than that of the forward end portion of a connected tube in its operational position giving a correct height positioning effect at said base end of said protrusion.

Advantageously, said free end of the positioner of the component receiving device is tapered such that it easily can enter the open space under the lower tube ridge surface. As should be readily understood the tapered free end facilitates correct alignment of the tube relative to the receiving device.

As will be also understood, two side surfaces of the positioner of the component receiving device can give a lateral guiding and/or positioning effect on the tube ridge, and thereby on the tube, when the positioner is introduced in the open space under the lower surface of the tube ridge, and also after such connection.

In an additional example embodiment, two side surfaces of the positioner can be slope-shaped and diverging so as to adapt the cross-section of the positioner to a commonly used shape of the saddle-like cross-section of the tube ridge. The degree of the inclination of the sloped side surfaces suitably is at least somewhat higher than that of the corresponding sloped side surfaces of the tube ridge. As above, this is to ensure that the upper contact surface of the tongue will be in contact with the lower tube ridge surface to achieve the correct height positioning, while at the same time giving an improved lateral positioning effect.

Thus, in an example embodiment of the component receiving device the positioner, at least partially, can have a cross-section in correspondence to the cross-section of said open space under the tube ridge such that an improved positioning effect will be obtained, in particular laterally. Such an embodiment can be particularly advantageous when using a component receiving device together with tubes having substantially the same cross-section of said open space under the tube ridge although other tube dimensions may vary.

According to another example embodiment, the component receiving device includes guiding means, in the following also referred to as a guiders, for laterally guiding an incoming tube. These guiders can be a help for the positioner to be aligned with the open space of the tube and can also provide a lateral operational positioning of a connected tube. These guiders could for example be two protruding arms, for co-operation with opposite side surfaces of the tube. The arms suitably extend at least substantially parallel to and on either side of the positioner.

In another example embodiment, the component receiving device further includes a space or area where a component is received. The space suitably is arranged for having one component, i.e. consecutively receiving one component at a time. This space has a central device ridge for supporting a received component, central meaning that the ridge is located in the line of the feeding of the components into said space or area. The positioner, specifically a tongue, and the device ridge are aligned with each other, such that the ridge follows after the positioner along the line of the component feeding direction. The device ridge together with a component stop which stops further feeding of a received component defines a component picking position, whereby a component located at the picking position can accurately be picked by a picking head.

According to a further example embodiment, the upper surface of the positioner of the component receiving device is located lower than the upper surface of the device ridge such that there is a distance or step between these two surfaces providing a stop for a connected tube. The stop defines a operational longitudinal position stop for the connected tube. The two surfaces suitably are located in such a way that a component leaving a connected tube travels downward onto the device ridge, considering the material thickness of the tube ridge, i.e. the distance between the upper and lower ridge surfaces.

It has been found that said material thickness of the tube ridge between the upper and lower ridge surfaces is substantially the same for many component tubes of various types and dimensions. Consequently, the height position of the upper tube ridge surface relative to the upper surface of the device ridge will not vary significantly, for what reason the conditions for the passage of a component from the tube end onto the device ridge will be under good control. This has been found also to alleviate problems with component climbing, because the step downwards from the tube ridge upper surface to the upper supporting surface of the device ridge can be suitably dimensioned and controlled.

In the above- and below-mentioned context, and for the purpose of clarity, the terms lateral and laterally refers to the lateral direction of a tube, a consecutively stored component inside a tube or a component at a component receiving device, i.e. perpendicular to the component feeding direction.

The above mentioned and other aspects, advantages, and features of example embodiments will be more fully understood from the following detailed description.

### Brief Description of the Drawings

Embodiments of the present invention will now be described, by way of example, with reference to the accompanying schematic drawings, in which
Fig. 1 is a perspective view of a prior art component receiving device and component tube,
Fig. 2 is a perspective view of an example embodiment of a component receiving device, a component tube and a supporting surface, according to the invention,
Fig. 3 is a perspective view of a further example embodiment of a component receiving device according to the invention,
Fig. 4 is a perspective view of yet another example embodiment of a component receiving device according to the invention,
Fig. 5 is a top plan view of the example embodiment of Fig. 2 where the component tube is in a connected operational engagement with the component receiving device,
Fig. 6 is a central sectional view of the example embodiment of Fig. 5 along a sectional line A-A,
Fig. 7 is a further cross-sectional view of the example embodiment of Fig. 5 along a sectional line B-B,
Fig. 8 is yet another cross-sectional view of the example embodiment of Fig. 5 along a sectional line C-C, and
Fig. 9 to 11 are side views of the example embodiment of the component receiving device and the component tube of Fig. 2, for schematically illustrating the connection of a component tube into an operational position relative to a component receiving device.

### Detailed Description of Preferred Embodiments

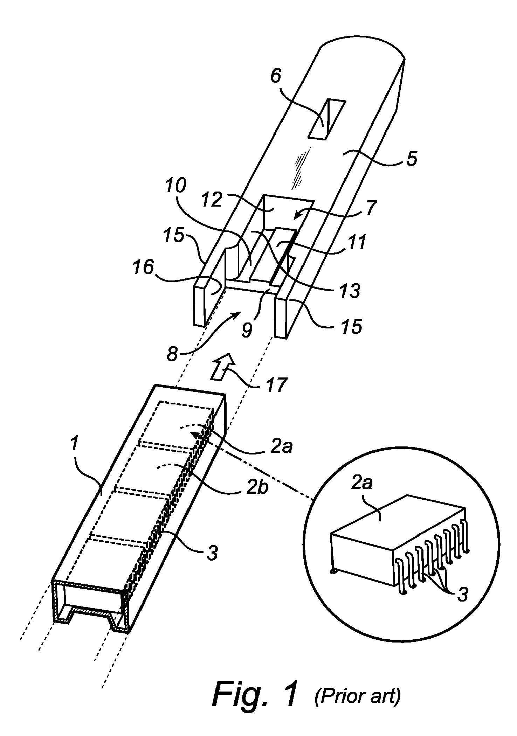

Fig. 1 is a perspective view of a prior art component receiving device 5 and a component tube 1 with consecutively stored components 2a and 2b therein. Conventionally, device 5 is secured on a supporting surface of a magazine of a component mounting machine (not shown), the lower base surface of device 5 thus resting on said supporting surface. Tube 1 is connected to device 5 by being pushed into contact with device 5 as indicated by arrow 17. When connected, tube 1 also rests on said supporting surface with its lower base surface. The component receiving device 5 is oblong to its shape and has a slit 6 used for fastening the device on said supporting surface by means of a screw, for instance. In a front end of device 5, there is a tube receiving space 8 for receiving and connecting the end of tube 1, and a component receiving space 7 for consecutively receiving components 2a and 2b from the tube 1 when the connected tube is in a operational position relative to component receiving device 5. A tube stopping surface 9 at the transition between spaces 7 and 8 is used for stopping the introduced tube 1, thereby positioning the tube in operational position (not shown). Component receiving space 7 is defined by a floor 10, a device ridge 11 on top of the floor 10, for supporting an incoming component, and a component stopping surface 12, for stopping an incoming component, also defining one end of a component picking position, which is later on disclosed in more detail. Additionally, component receiving space 7 is defined by side walls 13, for guiding a component as it travels into the picking position, as well as for holding the component in its picking position. Thus, these walls 13 define the component picking position in the lateral direction. The front ends of walls 13 are rounded and/or diverging at the inlet of space 7 to improve the guiding effect.

The prior art example embodiment of Fig. 1 is further provided with guiding means in the form of two projecting parallel non-resilient flat arms 15, wherein inner surfaces 16 of arms 15 guide an incoming tube in the lateral direction and holds tube 1 in the operational position, the tube end then being in engagement with stopping surface 9. Arms 15 may also be thin and of any material such that a resilient function is achieved.

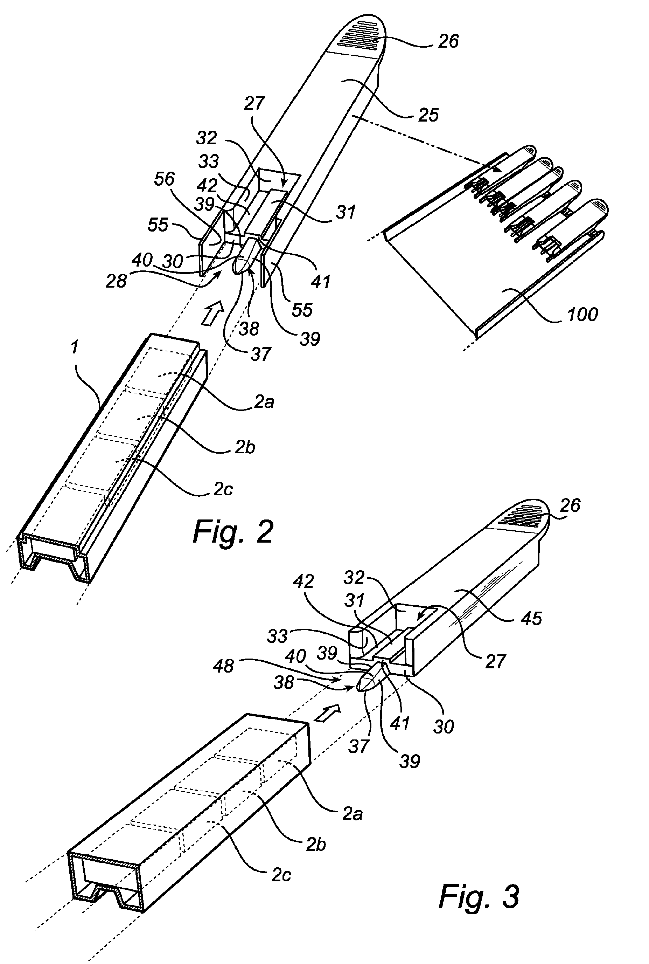

Fig. 2 is a perspective view of an example embodiment of a component receiving device 25 and a component tube 1 with consecutively stored components 2a, 2b and 2c etc., according to the invention. Conventionally, device 25 is located on a supporting surface 100 of a magazine of a component mounting machine (not shown), the lower base surface of device 25 thus resting on said supporting surface 100. Such a support is presented in the co-pending and co-assigning European Patent application filed on even date herewith, and incorporated herein in its entirety by reference.

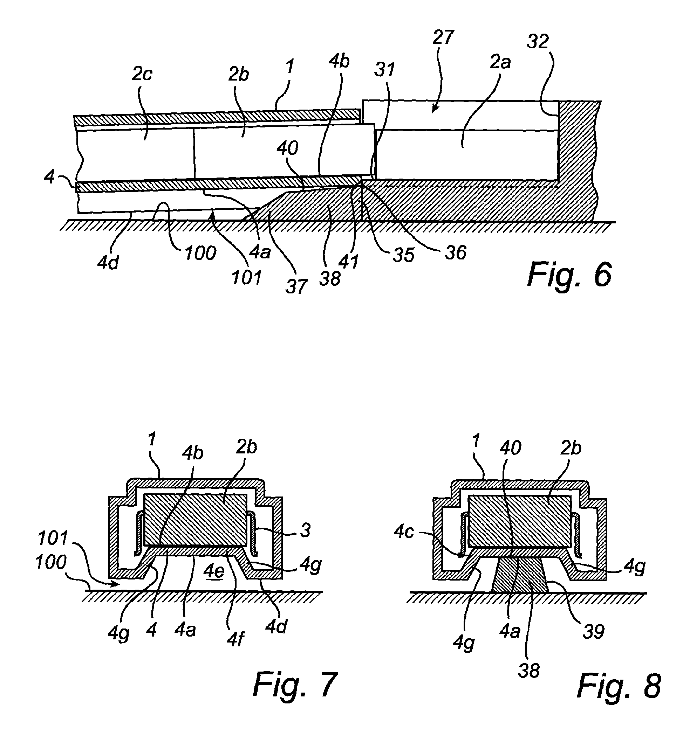

Component receiving device 25 is oblong to its shape and in a back end there is a handle 26 with grooves to facilitate grasping it. In the same way as in the prior art device, in the opposite front end of device 25 there is a component receiving space 27, for consecutively receiving components 2a, 2b, 2c etc. from a connected tube 1 when the tube is in an operational position relative to device 25. Device 25 also has a tube stopping surface 30, 41 for engaging and stopping an incoming tube 1, thereby stopping the tube in an operational position (see Fig 6, for instance). From the tube stopping surface 30, 41 a protruding part 38 protrudes centrally in a direction towards an incoming tube, with a shape of a tongue.

The tongue or protruding tongue 38 has an upper tongue surface 40 and a tapered free end 37. Upper tongue surface 40 is downwards sloping from the tube stopping surface 30, 41 towards the tapered free end 37, i.e. in the protruding direction. Moreover, the tapered free end 37 is ramp-shaped. From the upper tongue surface 40 two sloping side tongue surface portions 39 diverge downwards. One could say that the tongue 38 comprises two ramping portions, a first portion (the tapered free end 37) for laterally aligning an incoming tube and a second portion (sloped upper tongue surface 40) for positioning the tube into a correct height position.

The upper tongue surface 40 elevates and positions an incoming tube 1 by co-operating with a lower tube ridge surface 4a, as will be discussed more later on. Side surfaces 39 of the tongue are sloped while diverging downwards, which could provide a lateral guiding effect of an incoming tube end 1 into its operational position. The lower surface of the tongue is flat and on a level with the lower surface of device 25.

The component receiving device in Fig. 2 includes lateral guiding means in the form of protruding arms or guiding arms 55 with an inner surface 56 for guiding a tube 1 in the lateral direction and possible lateral holding of the tube in the operational position. Guiding arms 55 with two inner arm surfaces 56 define a tube receiving space 28, centrally at the bottom of which the positioning tongue 38 is provided.

The component receiving space 27 and thus the component picking position is defined by two side walls 33 being rounded at the space inlet, a floor 42 with a central device ridge 31 for supporting an incoming component on its upper surface and a component stopping surface 32, for stopping a received component. Stopping surface 32 thus defines the end of a component picking position, while walls 33 define the component picking position in the lateral direction. A surface portion between upper tongue surface 40 of tongue 38 and the upper surface of device ridge 31 forms a stopping step surface 41 for the end of a connected tube.

Device 25 of Fig. 2 may be of any material, such as a plastic or a metallic material. Though the component receiving space 27 of device 25 is arranged for receiving one component at a time, it will be understood that the component receiving space can be dimensioned for containing two or more components in series.

Fig. 3 is a perspective view similar to Fig. 2 and illustrating a further example embodiment of a component receiving device 45. This example embodiment is basically the same component receiving device as in Fig. 2, but without the guiding arms 55. Thus, the space surrounding the tongue 38 is here defined as a tube receiving space 48, which is not as well-defined as the tube receiving space 28 in the example embodiment of Fig. 2. The connection or holding of the tube in its operational position as well as the lateral guiding of an incoming tube end 1, can be achieved by means of the engagement of side tongue surface portions 39 of the tongue 38 with a corresponding tongue receiving space in the tube end. As should be understood, this embodiment is suitably used when the side tongue surface portions 39 of the tongue 38 engages with said corresponding tongue receiving space.

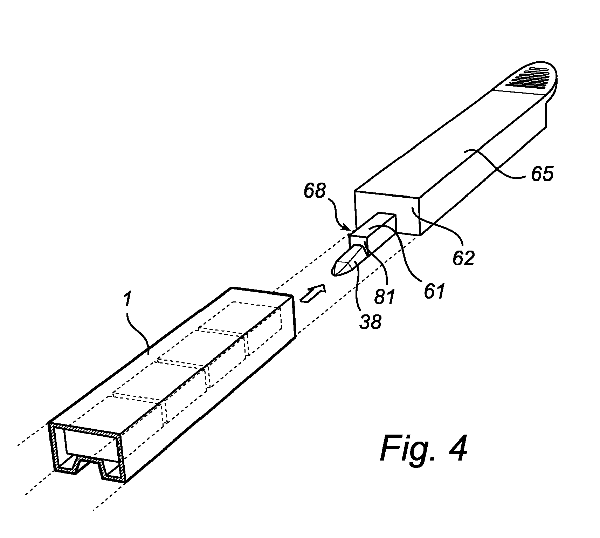

Fig. 4 is a perspective view illustrating another example embodiment of a component receiving device 65. This example embodiment is basically the same component receiving device as in Fig. 3, but without side walls 33 and floor 42, whereby the component receiving space 68 is an open space surrounding a device ridge 61 in the form of a protruding beam having a rectangular cross-section. Tongue 38 is aligned with ridge 61 and protrudes from the lower part of the end of ridge 61 while having a tube stopping step 81 thereabove. Ridge 61 protrudes from an end surface 62 of device 65 which will act as a component stopping surface defining the end of a component picking position. As will be understood, this embodiment is suitable for use in connection with components which safely ride on ridge 61 without requiring further lateral guidance or holding.

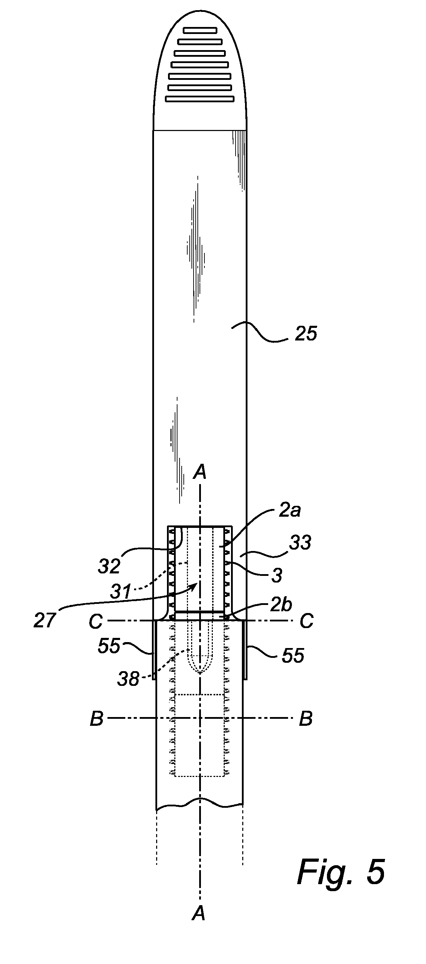

Fig. 5 is a top plan view of the example embodiment of Fig. 2 where component tube 1 has been brought in a connected operational position relative to component receiving device 25, see also Fig. 6 in this respect. The guiding arms 55 hold or secure the connected tube in the operational position. Furthermore, the arms 55 also provide lateral guiding of tube end of the tube when the tube is being connected. A first component 2a, received from the tube 1, is in contact with component stopping surface 32 of the component receiving space 27. This first component 2a is in the component picking position, waiting to be collected by a picking head. The body of component 2a is supported by the device ridge 31. Along both longitudinal, lateral sides of the first component 2a, there are component legs 3, which due to the device ridge 31 are elevated from floor 42 of component receiving space 27. The number and size of legs 3 of course depends on the type of component 2a. As will be understood, component 2a will be laterally guided and positioned by side walls 33. The front part of a second component 2b is also shown, which is positioned behind the first component 2a. This second component 2b exerts a force against the first component 2a and holds it in the picking position. The exerting force can be a combination of a gravitational force and vibrational force, when tube 1 is vibrated. After the first component 2a has been picked up, it is replaced by the second component 2b and so on.

Fig. 6 is a central sectional view of the example embodiment of Fig. 5, taken along a sectional line A-A. The guiding arms 55 of the component receiving device 25 in Fig. 5 are here omitted for illustrative purposes. Here the component tube 1 is in contact with stopping step surface 41 of a component receiving device 25, accordingly tube 1 is in its longitudinal operational position. Again, first component 2a is in contact with component stopping surface 32, and thus positioned on the device ridge 31 at the picking position in component receiving space 27. A second and a third component 2b, 2c are still supported on an upper component-supporting surface 4b of a tube ridge 4. A lower tube ridge surface 4a is in contact with a positioning surface portion 36 of the upper tongue surface 40 at an innermost part of a tongue base end 35 of the protruding tongue 38 of the component receiving device 25, i.e. the positioning surface portion 36 positions the height level of the lower tube ridge surface 4a and thus of the upper ridge surface 4b.

Moreover, the forward end portion of the tube 1 has an inclination or slope relative the supporting surface 100 since the tube end is elevated and in contact with the upper tongue surface 40 and more specifically the positioning surface portion 36 at the tongue base end 35. A middle part (not shown) of tube 1 is in contact with the supporting surface 100. A rear tube end (not shown) opposite the forward end of the tube 1 could also be aligned and in contact with the surface 100. Conventionally, the rear tube end is attached to a vibration motion generating device for obtaining a component feeding movement. As will be understood, such a motion generation can be arranged in many different ways as long as a feeding direction towards the forward end is achieved. One example of such a vibration motion generating device is presented in the co-pending and co-assigning European Patent application filed on even date herewith, and incorporated herein in its entirety by reference.

As illustrated a bottom base surface 4d of the tube 1 is here elevated above said support surface 100, which is also shown in Fig. 2. This elevation forms an air gap 101 between the tube base surface 4d and the support 100. The support surface 100 supports device 25 and also the rest of tube 1 in some suitable way.

Fig. 7 is a cross-sectional view of the example embodiment of Fig. 5 taken along a sectional line B-B and illustrating how components are supported by a tube ridge inside component tube 1. Tube ridge 4 has a saddle-like cross-section including a ridge top 4f and two diverging ridge sides 4g. Ridge top 4f has the upper ridge surface 4b and the lower ridge surface 4a. Under the ridge top 4f there is a downwardly open space 4e, in the forward end of which tongue 38 penetrates. 4d denotes the bottom base surface of the tube.

Component legs 3 protrude laterally and downwards from the body of component 2b, which is supported by the upper component-supporting surface 4b of tube ridge 4, which elevates component 2b such that the fragile component legs 3 are protected against damage.

Fig. 8 is yet another cross-sectional view of the example embodiment of Fig. 5 taken along a sectional line C-C. This cross-sectional view is similar to the cross-sectional view of the Fig. 6, but taken where tongue 38 is in engagement with tube 1, i.e. where the end of tube 1 is in contact with stopping surface 41. The guiding arms 55 of the component receiving device 25 in Fig. 5 are here omitted for illustrative purposes. Thus, upper surface portion 40 of tongue 38 is in contact with and co-operation with lower tube ridge surface 4a of ridge 4 of tube 1. The width of upper tongue surface 40 is considerably lesser than that of the lower tube ridge surface 4a, i.e. lateral guiding is provided by the guiding arms 55 (not shown).

Thus, in this shown embodiment the lateral guiding of the tube is provided by the not shown guiding arms 55. However, a person skilled in the art realizes that if the width of the upper tongue surface 40 is only somewhat lesser than the width of the lower tube ridge surface 4a, then the tongue with the upper tongue surface would provide lateral guiding of an incoming tube end of a tube 1. More specifically, it is the corners where the upper tongue surface 40 and side tongue surface portions 39 meet which provide the lateral guiding.

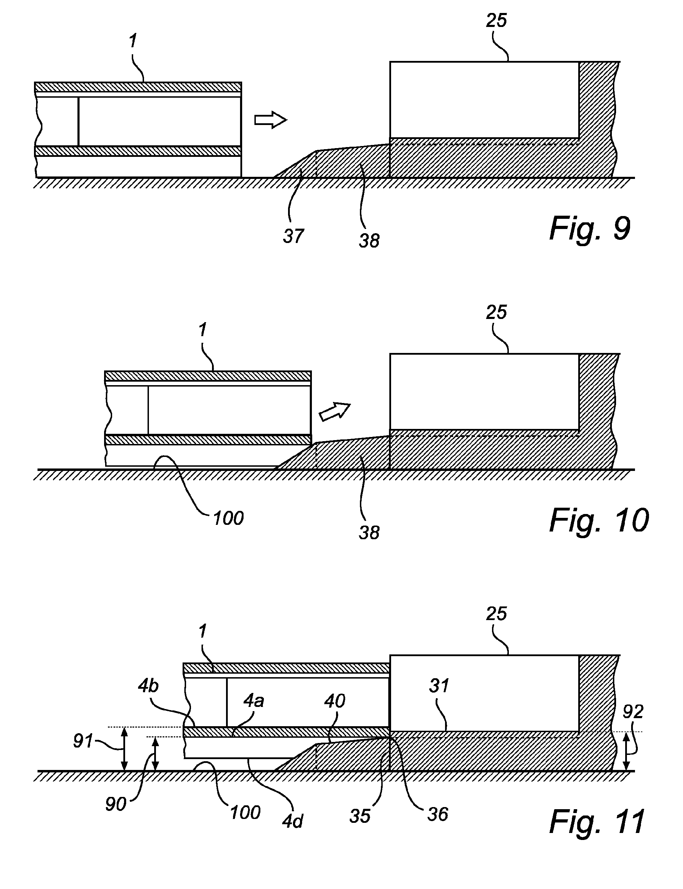

Figs. 9 to 11 are simplified side views of the example embodiment of the component receiving device and the component tube of Fig. 3, for schematically illustrating a method of positioning a component tube in an operational position relative to a component receiving device. Fig. 9 illustrates a component receiving device 25 with an incoming component tube 1. Tube 1 is moved (illustrated by the arrow) towards the tapered free end 37 of tongue 38, while being aligned therewith such that the tongue can start to penetrate into said open space 4e of the tube. Although the example embodiment of Fig. 9 to 11 is describing a moving tube relative a fixed component receiving device, it will be understood that a component receiving device can be moved relative a fixed tube, i.e. moving said protruding tongue into said open space of the tube.

Thereafter, as illustrated in Fig. 10, the lower tube ridge surface 4a of tube 1 co-operates with the ramp-shaped tapered free end 37 of tongue 38 of the component receiving device 25 or 45, whereby the tube end is elevated while the tube travels upwards and onto the sloped upper surface portion 40 of tongue 38.

Fig. 11 illustrates the tube 1 in its final operational position with regard to component receiving device 25. For illustrative purposes, Fig. 11 is showing a tube 1 which has no inclination, i.e. the bottom base surface of the tube is parallel to the supporting surface 100. At the innermost part of the tongue base end 35, i.e. where tube 1 is in contact with tube stopper 30 or 41, the lower tube ridge surface 4a at the tube end is now in contact and co-operation with upper tongue surface 40 of the tongue 38. The component receiving device is now ready to receive consecutively stored components 2a, 2b, 2c from the component tube 1.

The contact between said two surfaces determines a positioning height 90, i.e. a distance between supporting surface 100 and the contact between lower tube ridge surface 4a and upper tongue surface 40. Fig. 11 also illustrates a tube ridge level 91, i.e. the distance between supporting surface 100 and upper component-supporting surface 4b of a tube 1 in its final operational position. Furthermore, Fig. 11 illustrates a device ridge level 92, i.e. the distance between supporting surface 100 and the upper surface of device ridge 31. A component leaving tube 1 and entering device ridge 31 travels a downward distance, which is the difference between tube ridge level 91 and device ridge level 92. Preferably, this difference is small to obtain a smooth transition from the tube 1 to the component receiving device 25. Moreover, this difference depends on the height difference between positioning height 90 and tube ridge height 91, which is basically the material thickness of the tube ridge 4.

Accordingly, a transition from a tube 1 to a device 25 depends on the material thickness (difference between 90 and 91) of the tube ridge 4. Conventionally, the material thickness of the tube ridge only somewhat differs from one tube to another. This creates a well-defined step from the tube ridge level 91, i.e. the component supporting surface 4b, down to the device ridge level 92, i.e. the upper surface of device ridge 31. Consequently, according to the invention there is provided a well-defined step giving a secure, smooth and reliable transition, contrary to prior art.

The invention has mainly been described above with reference to a few embodiments. However, as is readily appreciated by a person skilled in the art, other embodiments than the ones disclosed above are equally possible within the scope of the invention, as defined by the appended patent claims.

## Claims

1. A component receiving device for consecutively receiving a plurality of components from a connected component tube arranged for containing a plurality of consecutively stored components and having a tube ridge at the bottom of the tube for supporting the plurality of components, the tube ridge having a saddle-like cross-section with an upper component-supporting surface and with an opposite lower tube ridge surface facing a downwardly open space therebelow, said component receiving device comprising
positioning means for co-operation with a said lower tube ridge surface for positioning a connected tube in a predetermined, operational position relative to the component receiving device.

2. The component receiving device of claim 1, wherein said positioning means for co-operation with a said lower tube ridge surface comprises a protruding tongue, having a tongue base end where said protruding tongue protrudes from said component receiving device and an opposite free end, for penetrating into said open space of a connected tube and engagement with said lower tube ridge surface of a said connected tube.

3. The component receiving device of claim 2, wherein said tongue comprises an upper tongue surface for engagement with said lower tube ridge surface of a said connected tube.

4. The component receiving device of claim 3, wherein said upper tongue surface comprises a positioning surface portion at the tongue base end for co-operation with a lower tube ridge surface of a tube end portion of a connected tube.

5. The component receiving device of claim 4, wherein said positioning surface portion is a laterally extending flat surface.

6. The component receiving device of claim 5, wherein said laterally extending flat surface has a lateral extension that is adapted to that of a said lower tube ridge surface of a tube to be connected.

7. The component receiving device of any one of claims 3 to 6, wherein said upper tongue surface is sloping downwards along a protruding direction from said positioning surface portion towards said free end.

8. The component receiving device of any one of claims 2 to 7, wherein said free end of said tongue comprises a ramp-shaped portion for ramping a said lower tube ridge surface of a connected tube onto said upper tongue surface.

9. The component receiving device of any one of claims 2 to 8, wherein said tongue comprises at least two opposite side tongue surface portions for laterally positioning and/or guiding a connected tube.

10. The component receiving device of claim 9, wherein said at least two opposite side tongue surface portions are slope-shaped and diverging.

11. The component receiving device of any one of claims 2 to 10, comprising a component receiving space or area having a device ridge with an upper surface for supporting consecutively received components, said device ridge following and being aligned with said tongue in the component feeding direction.

12. The component receiving device of claim 11, wherein said upper tongue surface is distanced by a step below said upper surface of the device ridge, said step being dimensioned such that a component leaving a connected tube travels downward from the tube ridge onto said device ridge.

13. The component receiving device of claim 12, wherein said step is an operational position stop for a connected tube.

14. The component receiving device of any one of claims 11 to 13, wherein said component receiving space or area defines a component picking position.

15. The component receiving device of any one of claims 2 to 14, comprising guiding means for laterally guiding side surfaces of a tube to be connected such that said protruding tongue is guided into said open space of the tube when bringing the device and the tube into operational engagement and/or for laterally positioning a connected tube.

16. The component receiving device of claim 15, wherein said guiding means comprises two protruding arms for engagement with two opposite side surfaces of a connected tube, the arms extending at least substantially parallel to and on either side of said protruding tongue.

17. A component feeding apparatus, comprising
a component tube, arranged for containing a plurality of consecutively stored components and having a tube ridge at the bottom of the tube for supporting the plurality of components, said tube ridge having a saddle-like cross-section with an upper component-supporting tube ridge surface and an opposite lower tube ridge surface, facing a downwardly open space therebelow, and
a component receiving device connected to said tube for consecutively receiving components from said tube into a component receiving space having a device ridge for supporting a received component, the component receiving device comprising positioning means for co-operation with said tube for positioning the tube in a predetermined, operational position relative to the component receiving device,
wherein said positioning means comprise means extending into said downwardly open space of said tube and being in co-operation with said lower tube ridge surface such that the tube ridge and the device ridge have a pre-determined height position relative to each other.

18. The component feeding apparatus of claim 17, wherein said positioning means being in co-operation with said tube ridge lower surface comprises a protruding tongue, having a tongue base end where said protruding tongue protrudes from said component receiving device and a free end, in engagement with said lower tube ridge surface.

19. The component feeding apparatus of claim 18, wherein said protruding tongue comprises an upper tongue surface in engagement with said lower tube ridge surface and a ramp-like portion at said free end of the tongue.

20. The component feeding apparatus of claim 19, wherein said upper tongue surface comprises a positioning surface portion at the tongue base end in co-operation with said lower tube ridge surface of said connected tube at the end of the tube.

21. The component feeding apparatus of claim 20, wherein said positioning surface portion is a laterally extending flat surface.

22. The component feeding apparatus of any one of claims 19 to 21, wherein said upper tongue surface is sloping in a protruding direction from said positioning surface portion of said tongue base end towards said free end.

23. The component feeding apparatus of any one of claims 19 to 22, comprising a step between said upper tongue surface and an upper component-supporting surface of the device ridge, said step being a positioning stop for the tube ridge end surface of the tube.

24. The component feeding apparatus of claim 23, wherein the height of said step is less than the tube cross-sectional height between said upper and lower ridge surfaces of the tube.

25. The component feeding apparatus of any one of claims 18 to 24, wherein said device ridge is located in a component receiving space or area defining a component picking position.

26. The component feeding apparatus of any one of claims 18 to 25, wherein said component receiving device further comprises guiding means for laterally guiding said tube such that said protruding tongue is aligned with said downwardly open space of the tube and/or laterally positioning the tube.

27. The component feeding apparatus of claim 26, wherein said guiding means comprises at least two protruding, resilient arms for engagement with two opposite side surfaces of said tube.

28. In a combination of
a component tube, arranged for containing a plurality of consecutively stored components and having a bottom tube ridge for supporting the plurality of components, the tube ridge having a saddle-like cross-section with an upper component-supporting surface and an opposite lower tube ridge surface facing a downwardly open space therebelow, and
a component receiving device, arranged for connection with said tube to consecutively receive components from said tube and comprising means for co-operation with said tube for positioning said tube in a predetermined operational position relative to said component receiving device when said tube is connected to said component receiving device,
use of said lower surface of said tube ridge for positioning the tube in said predetermined, operational position relative to the component receiving device.

29. The use of claim 28 wherein said lower surface of said tube ridge is brought into engagement with a positioning surface on a tongue protruding from the component receiving device.
